Europäisches Patentamt

European Patent Office

Office européen des brevets

(19)

(11) Publication number: **0 244 367**

**A2**

(12) # EUROPEAN PATENT APPLICATION

(21) Application number: **87830113.4**

(22) Date of filing: **25.03.87**

(51) Int. Cl.⁴: **H 01 L 27/08**

(30) Priority: **21.04.86 IT 8361686**

(43) Date of publication of application:
**04.11.87 Bulletin 87/45**

(84) Designated Contracting States: **DE FR GB NL**

(71) Applicant: **SGS MICROELETTRONICA S.p.A.**
**Stradale Primosole 50**
**I-95121 Catania (IT)**

(72) Inventor: **Picco, Paolo**
**Via Carlo Alberto 39**
**I-20052 Monza (IT)**

**Cavioni, Tiziana**
**Via Massara 25**
**I-28048 Verbania (IT)**

**Maurelli, Alfonso**
**Via Cilea 183**
**I-80127 Napoli (IT)**

(74) Representative: **Pellegri, Alberto et al**
**c/o Società Italiana Brevetti S.p.A. Via Cavour, 9**
**I-21100 Varese (IT)**

(54) **Mos type integrated semiconductor device with nonuniform thickness of gate oxide and process for fabricating it.**

(57) In an integrated MOS device, MOS transistors belonging to circuit sections destined to operate at different voltages are provided with an insulating layer of gate oxide of thickness suitably differentiated through a modification of known fabrication processes, increasing it in the case of transistors subject to higher supply voltages.

Fig.13

EP 0 244 367 A2

**Description**

## MOS TYPE INTEGRATED SEMICONDUCTOR DEVICE WITH NONUNIFORM THICKNESS OF GATE OXIDE AND PROCESS FOR FABRICATING IT

The present invention relates to MOS type (Metal-Oxide-Semiconductor) semiconductor devices.

Particular semiconductor devices, known as microprocessors among experts, do implement two distinct kinds of functions. A first function is that of input data management, that is their manipulation and transformation. A second function is that of memory; it is in fact a function auxiliary to the first one, because data management often implies their (momentary) storage.

In another class of semiconductor devices, namely: memories, the hierarchy between the two functions is reversed : it is in fact the data management function to be auxiliary to the primary function of storing them.

Microprocessors and memories are therefore conceptually separable in two parts corresponding to the two functions mentioned. Structurally, on a single device the two distinct regions are easily recognizable. These regions may be realized with different circuital solutions dictating the choice among different fabrication processes.

Adoption of the ROM type memory (Read Only Memory) results advantageous from a point of view of the fabrication process, as variations with respect to the process used for the region devoted to data management are not necessary. However this implies programming of the memory region during the fabrication process itself and this does not allow subsequent modifications for adapting characteristics to a particular application different from that contemplated originally for the particular device.

In order to have a greater flexibility of utilization, it is necessary to change the type of memory, using the so-called EPROM (Erasable Programmable Read Only Memory) or EEPROM (Electrically Erasable Programmable Read Only Memory).

Adoption of such a type of memory gives origin to a technical problem: the physical principle of operation of such types of memory requires the utilization of high voltages. Their process of fabrication, therefore, results different, in general, from the one utilized for ROM type memories and thence different from the one theorically usable for fabricating the portion of the device dedicated to data manipulation and management, normally working with a low voltage.

Fabrication processes of EPROM or EEPROM memories have been known for a long time and constitute an important branch of the technology of semiconductor devices. As compared with the fabrication processes of low supply voltage devices, they are more complex and longer, besides contemplating a reduced density of integration. Thus they are more expensive, both in terms of fabrication as well as in terms of area requirement on the semiconductor chip.

Lately a number of expedients have been proposed and utilized commercially for modifying the basic fabrication process of low voltage MOS devices with the aim of allowing the simultaneous realization of EPROM or EEPROM memory regions together with a low supply voltage region for data management on the same substrate.

The present invention is particularly advantageous for making microprocessors with EPROM or EEPROM type of memory, by proposing an innovative and particularly effective way of making compatible a typical fabrication process for low voltage MOS devices with the utilization, in selected regions of the integrated circuit, of a voltage high enough to permit the operation of the memory devices.

As shown in the series of **figures from 1 to 7**, a normal process for fabricating a MOS device contemplates the use of a semiconductor substrate 1 of a first type of conductivity (typically p doped monocrystalline silicon), onto which a thin layer of oxide 2 is formed and which is subsequently covered by a further layer 3 of a suitable inert material, usually silicon nitride.

In this layer, by means of a photolithographic process known as "masking", are defined the regions destined to contain the transistors. In said figures these regions are indicated with the numbers 4 and 5. In regions comprised among these, the doping level of the substrate 1 is incremented by means of an appropriate step of introduction into the silicon of a dopant of the same type of conductivity of the one already present in the silicon substrate. Such a layer, having a higher doping level, 6 is referred to as isolation layer.

At this point of the process a prolonged oxidizing treatment is carried out. Where the inert material (e.g. silicon nitride) is present, that is on the regions 4 and 5, the oxide does not grow. Elsewhere, instead, a thick layer of oxide 7 grows which, by standard terminology, is called field oxide.

Simultaneously the dopant of the region underneath 6 diffuses and the region assumes the dimensions shown.

At this point, both the layer of inert material and the thin layer of oxide grown in the first step of the process are removed and, under conditions of particular freedom from chemical contamination, a new layer of oxide is grown in order to form the so-called gate oxide 8.

A layer of conductive material, e.g. polycrystalline silicon deposited from vapor phase and shown with the number 9' in Fig. 4, is deposited over the whole surface.

A new masking operation is performed by means of which, in the layer of conductive material are defined the areas which will constitute the electrodes 9 and 10, that is the gate electrodes of the transistors. Atoms of a dopant of a second type of conductivity are thence introduced in a high dosage into the portions of the original regions 4 and 5 not covered from the gate electrodes. In these regions 11, 12, 13 and 14, will be formed the source and drain electrodes of the transistors.

The process continues with the deposition of an insulating layer 15, e.g. of silicon oxide deposited from vapor phase, through which, by means of a further masking operation, are opened the holes for the contacts 16, 17, 18 and 19 (besides those for the contact with the gate electrodes outside the section depicted in the drawing). Deposition of a metal layer 20 and the definition of the conductive paths by means of a last masking operation, complete the series of essential steps of the fabrication process.

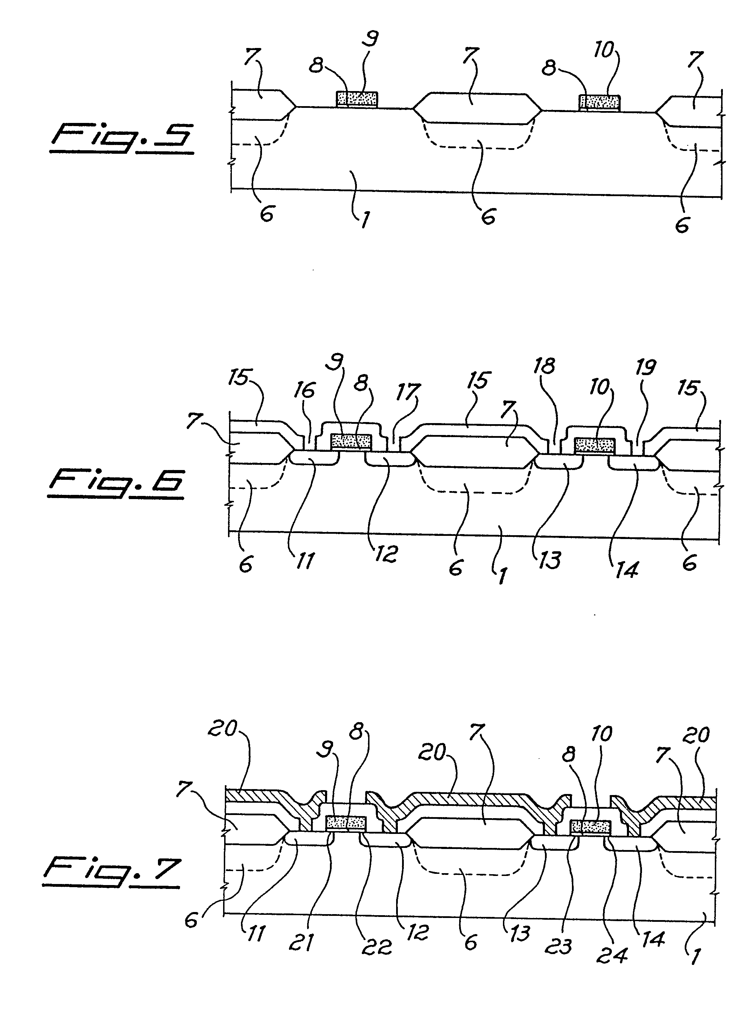

The structure obtained by means of such a standard fabrication process for low voltage MOS devices, which may be represented by two adjacent MOS transistors in its more simplified version, but which in reality may be composed of a number as large as desired of such transistors, is depicted in Fig. 7. The critical points, from the point of view of electrical breakdown, are represented by the regions where the gate electrode superimposes on the source and drain regions. Such points, shown in Fig. 7 by the numbers 21, 22, 23 and 24, are easily subject to dielectric failure (voltage breakdown) if the applied voltage is too high. The weakness of these points is so much more pronunced the more the thickness of the insulating layer of oxide which is present underneath the gate oxide is decreased.

Moreover, the electric fields near the drain-substrate junction are also a critical parameter for the correct operation of the MOS device. Their intensity may in fact create an anomalous increase of the electric charge carriers, thus increasing the current flowing through the device and altering, therefore, its characteristics.

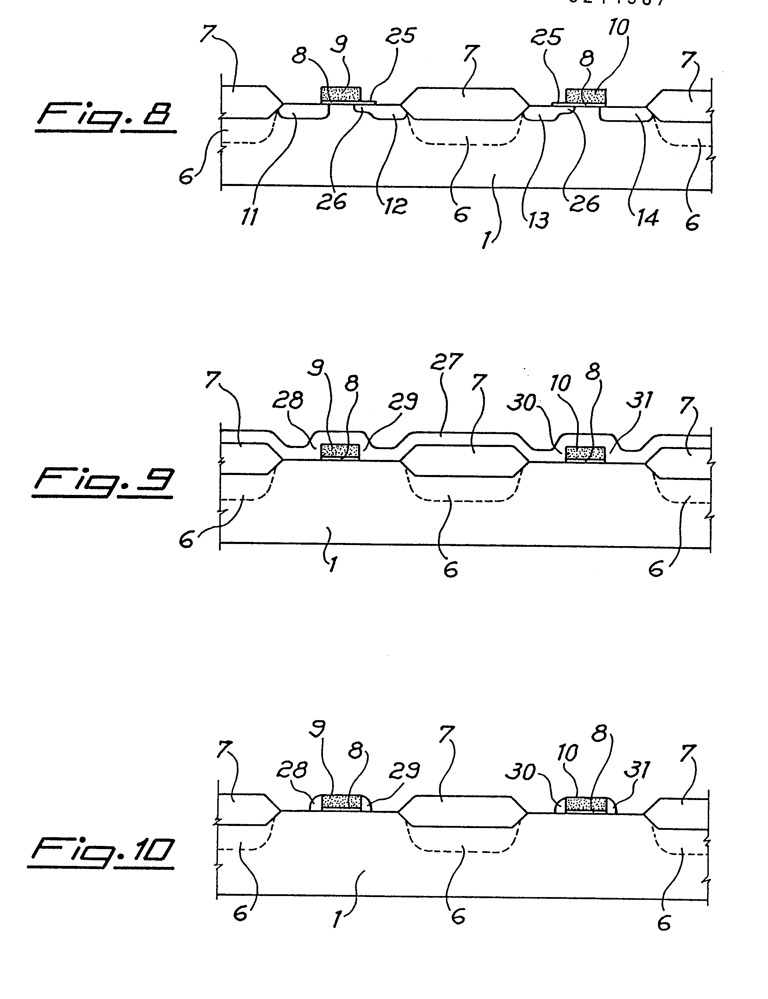

Thus the problem is of reducing the intensity of the electric fields at the superimposition point between the gate electrode and source or drain potentials and in the substrate in the proximity of the drain region. A first known solution of the problem implies a further masking and doping operation with respect to the sequence of operations of the normal fabrication process. Precisely, during the process step illustrated in Fig. 5, a mild oxidation is carried out in order to to grow a thin oxide layer on the regions destined to become source and drain regions, respectively, of the transistors. With reference to Fig. 8, in this thin layer of oxide is defined an area 25, adjacent to the gate, and only outside this area the heavy implantation of the dopant, typical of source and drain regions of the transistors, is actually performed. Viceversa, directly under this area of oxide 25, a lighter doping is produced (i.e. the region identified with the number 26). In this way it is possible to determine a decrease of the intensity of the electric field in the substrate near the drain region, thanks to a well known effect tied to the extension of the depletion regions inside the semiconductor crystal.

A different way of obviating to the same mentioned technical problem, contemplates, always during the process step shown in Fig. 5, the deposition of a layer of dielectric material 27 over the whole surface of the substrate as shown in Fig. 9. By means of known techniques of anisotropic attack, i.e. by R.I.E. (Reactive Ion Etching) attack in plasma, the layer of dielectric material 27 is entirely removed leaving, along the edges of the gate electrode a residue of said layer of dielectric material indicated in Fig. 7 with the numbers 28, 29, 30 and 31, which will act as "spacer" during the subsequent step of implantation and diffusion of the dopant to form the source and drain regions of the transistors, thus obtaining an effect similar to that obtained by means of the additional layer of oxide 25 shown in Fig. 8. Both the described known techniques present a serious drawback determined by the fact that the light doping region in proximity of the drain electrode introduces an additional resistive element with respect to the more simple structure, previously described and suitable for circuit sections destined to work with relatively low voltage levels. This determines a degradation of the transistors'characteristics besides making more complicated designing and fabricating the devices.

A primary objective of the present invention is to provide an integrated semiconductor device of the MOS type comprising MOS transistors for low working voltage and transistors for high working voltage which is free of the drawbacks of the devices of the prior art.

It is a further objective of the present invention to provide an improved fabrication process for MOS type integrated devices.

It is another objective of the present invention providing MOS type integrated devices such as microprocessors and/or EPROM or EEPROM type memories.

These objectives and advantages are obtained by the MOS type integrated semiconductor device of the present invention which may comprise, essentially, a number as high as desired of MOS transistors of the same type and wherein the insulating layer of oxide present under the gate electrode of the MOS transistors destined to operate with relatively high working voltages has a thickness which is substantially increased in comparison with the thickness of the same insulating layer of oxide present under the gate electrode of MOS transistors destined to operate with relatively low working voltages.

With the exception of this difference between the MOS transistors belonging to the low voltage circuit section and the MOS transistors belonging to the high voltage circuit section of the same integrated circuit, all other structural features of the MOS transistors may advantageously remain substantially identical. That is forming light doped regions near the drain region along the edges of the gate electrode in transistors destined to work at relatively high voltage, which is typical of the prior techniques, may be advantageously avoided. In this way, besides avoiding introduction of said additional resistive elements in the structure of the transistors, a burdensome complication of the normal fabrication process required according to the prior described known techniques is also avoided.

According to the present invention, the devices may in fact be fabricated by a process which, substantially, is no more complicated than the normal low voltage process. Notwithstanding the process of the invention requires an additional masking operation with respect to the basic process, such an operation does not have a critical character and therefore does not imposes sacrifices in terms of density of integration, as well as not requiring special techniques of area definition.

A detailed description of the invention will follow, with reference also to the annexed drawings wherein:

- **Figures from 1 to 7** illustrate the essential steps of the sequence of operations of a normal fabrication process for MOS type integrated devices, as already described in the preamble;

- **Fig. 8** shows one of the known techniques, modifying the normal fabrication process, for increasing the breakdown voltage of MOS transistors destined to operate with relatively high voltage, as already described in the preamble;

- **Figures 9 and 10** show another of the known techniques, also described in the preamble, for modifying the normal fabrication process with the aim of increasing the breakdown voltage of MOS transistors destined to operate with relatively high voltage;

- **Figures 11, 12 and 13** show the characterizing steps of the process of fabrication of the present invention and, in particular, Fig. 13 shows schematically the structure of the MOS type integrated semiconductor device object of the present invention.

All series of figures show partial microsections of a MOS type integrated device, schematically illustrating a section relative to two single MOS transistors one adjacent to the other in the device. As it is well known to the expert of the field, such an elementary section may be considered representative of the structure of the whole device which obviously may contain a number as high as desired of transistors and eventually of other circuit components. Such a structure is characteristic also of integrated devices known as microprocessors and/or as memories, be the latter of the PROM, EPROM or EEPROM type.

In all figures, similar numbers have been used for indicating similar parts except where differently indicated in the description.

In contrast with the known techniques, i.e. the standard fabrication process for MOS devices for low voltage, previously described with reference to the series of figures from 1 to 7, as well as the previously discussed variations of the standard process representing the known techniques used for increasing the resistance to the breakdown of some of the MOS transistors of the integrated device, these also previously discussed with reference respectively to figures 8, 9 and 10, the fabrication process of the present invention does not contemplates the formation of a relatively low doping level region along the edge of the gate electrode adjacent to the drain region of the MOS transistors. For simplicity's sake, the fabrication process of the invention may be adequately illustrated by describing the additional operations which characterize it with respect to the sequence of steps of the standard fabrication process previously described.

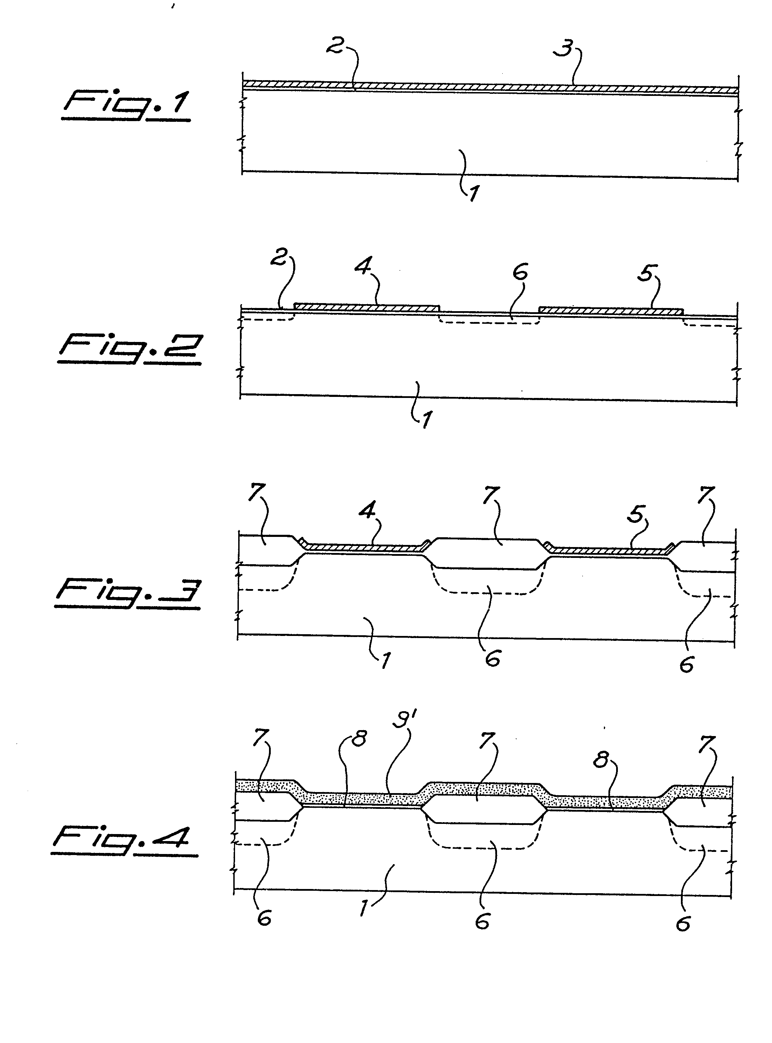

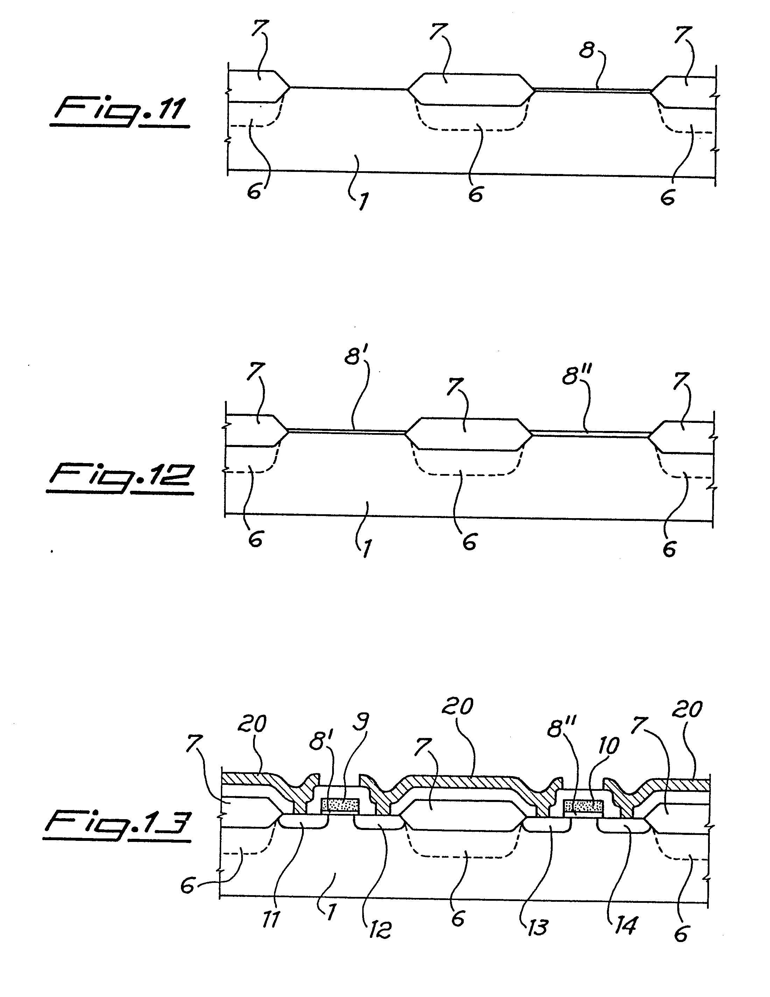

According to the process of the invention, after having provided to implant, in the monocrystalline silicon substrate doped with impurities of a first type of conductivity, impurities of the same type for forming a dopant enriched region 6, as shown in Fig. 2; after having provided to grow the layer of field oxide 7 in the areas not covered by the nitride as shown in Fig. 3 and after having removed the layer of nitride from the areas 4 and 5 together with the thin underlying layer of oxide and having re-oxidized again the surface of the monocrystalline silicon to form the thin gate oxide layer 8, an appropriate additional masking operation is performed defining the areas which will contain transistors destined to operate with supply voltage realtively high (i.e. EPROM or EEPROM memory circuit sections). In correspondence of unmasked areas the already formed layer of gate oxide is removed. After having removed the masking material, the section will appear as shown in Fig. 11. At this point, under the typical conditions of particular freedom from contaminants, the step of growing the insulating layer of gate oxide is repeated, under similar environmental conditions of the same operation already performed.

The result is that a configuration as the one shown in Fig. 12 is obtained, wherein on the area destined to the formation of a low voltage transtistor a new thin layer of gate oxide 8' is formed again, while, on another adjacent area, where a MOS transistor destined to operate at high voltage will be formed, the layer of gate oxide, indicated with 8'', will result thickened.

Thus, according to the process of the invention, the step of forming the layer of gate oxide is repeated at least twice. After the first step of formation of said gate oxide layer, an additional masking step is carried out followed by the removal of the layer of gate oxide already formed from the areas where low voltage MOS transistors will be formed.

By the second (or repeated) operation, the layer of gate oxide is re-formed over said areas, layer which will normally have a thickness comprised between 250 and 400 Å, while the layer of gate oxide already present over the areas of the high voltage transistors will have its thickness increased by a similar amount.

It is clear that the first stage of gate oxidation may be protracted for the time necessary to form the desired thickness of the oxide and determined exclusively by the characteristics (in first place the breakdown voltage) which one desires to obtain for MOS transistors belonging to circuit sections of the device which will have to operate at a relatively high voltage. Similarly, the second stage of gate oxidation may be advantageously conducted in function of the characteristics that one desires to obtain for MOS transistors belonging to the low voltage circuit section of the integrated device.

After having reached the structural configuration represented in Fig. 12, the fabrication process of the device may proceed in a conventional fashion, as shown in the series of figures from 4 to 7, conserving the two different thicknesses of the insulating layer of gate oxide existing over different areas of the device being fabricated.

The characteristic structure of the MOS type integrated semiconductor device of the present invention is schematically shown in the section of Fig. 13. As it is easily observed, between the two adjacent MOS transistors, the only structural difference is represented by the fact that while the transistor shown on the left-hand part of the section has a thickness of the insulating layer of gate oxide 8' relatively small, the transistor represented in the right-hand portion of the same section has a thickness of the insulating layer of gate oxide 8'' markedly greater than the first transistor.

Obviously, though having shown for ease of illustration the two transistors as being adjacent one to the other and with an entirely simplified type of connection between them, it is intended that the innovative character of the present invention contemplates the co-existence of transistors different the ones from the others in the sense described on the same substrate; their being close to each other and/or their electrical connection both being unrelevant aspects to the end of practising the present invention.

Deliberately also, in the annexed drawings, the different types of conductivity relative to the different regions of the monocrystalline semiconductor of substrate have not been indicated in so far the transistors may be of the n-channel or of the p-channel type.

As it will be clear to the expert of the field, the peculiar integrated structure of the invention with nonuniform thickness of the gate oxide may be fabricated also through processes modified in a more or less substantial way with respect to the particular process of the present invention though remaining within the scope of the present invention.

## Claims

1. A MOS type integrated device comprising at least two MOS transistors wherein the insulating layer of oxide present under the gate electrode of at least one of said MOS transistors has a thickness substantially different from the thickness of the insulating layer of oxide present under the gate electrode of another of said MOS transistors.

2. A device according to claim 1 comprising at least a circuit section containing a plurality of MOS transistors destined to operate with a first supply voltage and at least another circuit section containing a plurality of MOS transistors destined to operate with a second supply voltage greater that said first supply voltage;

the MOS transistors belonging to said second circuit section having an insulating layer of oxide under the respective gate electrodes of thickness substantially greater than that of MOS transistors belonging to said first circuit section.

3. In a process for fabricating MOS type integrated semiconductor devices containing MOS transistors destined to operate with a first supply voltage and MOS transistors destined to operate with a second supply voltage higher than said first voltage, the improvement characterized in that the process comprises the following stages:

a) forming a first layer of gate oxide over areas where said transistors will be formed;

b) masking the layer of oxide formed during the previous stage in correspondence of areas where said MOS transistors destined to operate with said second supply voltage will be formed;

c) removing the layer of oxide formed during the stage a) from areas unmasked by the mask set during the stage b);

d) removing the residual masking material; and

e) forming a second layer of gate oxide over the areas where said transistors will be formed.

0244367

Fig.1

Fig.2

Fig.3

Fig.4

0244367

_Fig.5_

_Fig.6_

_Fig.7_

_Fig.8_

_Fig.9_

_Fig.10_

0244367

Fig.11

Fig.12

Fig.13